(19) Europäisches Patentamt
European Patent Office
Office européen des brevets

(11) Veröffentlichungsnummer: 0 336 276
A2

# (12) EUROPÄISCHE PATENTANMELDUNG

(21) Anmeldenummer: 89105523.8

(51) Int. Cl.[4]: C07F 7/08

(22) Anmeldetag: 29.03.89

(30) Priorität: 02.04.88 DE 3811241

(43) Veröffentlichungstag der Anmeldung:
11.10.89 Patentblatt 89/41

(84) Benannte Vertragsstaaten:
AT BE CH DE ES FR GB IT LI NL SE

(71) Anmelder: HOECHST AKTIENGESELLSCHAFT
Postfach 80 03 20
D-6230 Frankfurt am Main 80(DE)

(72) Erfinder: Wilharm, Peter, Dr.
Am Scheuerling 3
D-6200 Wiesbaden(DE)
Erfinder: Fuchs, Jürgen
Flörsheimer Strasse 40
D-6093 Flörsheim-Wicker(DE)

## (54) Silylierungsreagenzien zur Herstellung von in wässrigem Alkali löslichen, Silanylgruppen in der Seitenkette enthaltenden Bindemitteln.

(57) Es wird ein Silylierungsreagenz zur Herstellung von in wäßrigem Alkali löslichen, Silanylgruppen in der Seitenkette enthaltenden Bindemitteln vorgestellt, daß dadurch gekennzeichnet ist, daß das Reagenz der allgemeinen Formel I

$(A - B_n)_m C$ (I)

entspricht, worin

A eine Silanylgruppe mit mindestens 2 miteinander verknüpften Siliciumatomen insgesamt, aber nicht mehr als 3 miteinander verknüpf-ten Siliciumatomen einer unverzweigten Kette aus Siliciumatomen,

B eine Brückengruppe und

C eine funktionelle Gruppe, die in der Lage ist, mit aromatischen und/oder aliphatischen bzw. cycloaliphatischen Hydroxylgruppen eine kovalente Bindung zu knüpfen, sowie

n 0 oder 1 und

n 0 oder 1 und

m 1 oder 2

bedeuten.

Die mit den beschriebenen Silylierungsreagenzien hergestellten Bindemittel sind in wäßrigem Alkali löslich, zeigen eine hohe Plasmaätzbeständigkeit, eine hohe Lagerstabilität und sind beständig gegenüber Strahlung mit einer Wllenlänge von größer als 300 nm.

EP 0 336 276 A2

# Silylierungsreagenzien zur Herstellung von in wäßrigem Alkali löslichen, Silanylgruppen in der Seitenkette enthaltenden Bindemitteln

Die Erfindung betrifft Silylierungsreagenzien, die zur Herstellung von in der Seitenkette Silanylgruppen tragenden, in wäßrigem Alkali löslichen Bindemitteln geeignet sind.

Die Mikrolithographie erfordert insbesondere im Submikronbereich bei steigender Auflösung und gleichzeitig abnehmender Fokustoleranz zur Strukturierung von Substraten mit komplizierter Topographie die Anwendung von Mehrlagensystemen. Dabei wird das Zweilagensystem aufgrund der einfacheren Prozessierbarkeit bevorzugt.

Gewöhnlich befindet sich auf dem Substrat eine komplizierte Topographie, die durch in der Fertigung von mikroelektronischen Schaltkreisen üblichen Prozeßschritte, wie beispielsweise Metallisierung, Oxidabscheidung, Epitaxie etc., hervorgerufen wird.

Beim Zweilagenverfahren wird das topographisch relativ unebene Substrat durch eine sogenannte Planarisierungsschicht eingeebnet. Als Materialien für die Planarisierungsschicht werden beispielsweise Polymere verwendet, die sich im nachfolgenden Plasmaätzprozeß gut ätzen lassen.

Auf die Planarisierungsschicht wird die eigentliche Resistschicht aufgebracht, die bildmäßig belichtet wird. Nach dem Entwickeln der - je nach angewendeten Verfahren (positiv oder negativ arbeitend) - belichteten bzw. nicht belichteten Bereiche wirkt die nicht entfernte Resistschicht als Maske für das Plasmaätzen der darunter jetzt bildmäßig freiliegenden Planarisierungsschicht. Die Resistschicht muß daher plasmaätzbeständig, insbesondere gegenüber Sauerstoff-Plasmen sein, und gleichzeitig auch hochaufgelöste Strukturen zulassen. Die Herstellung hochaufgelöster Strukturen mittels Mehrlagenverfahren, insbesondere Zweilagenverfahren, wird beispielsweise von E. Reichmanis, G. Smolinsky und C.W. Wilkins in Solid State Technology, August 1985, Seite 130, ausführlich beschrieben. Eine Übersicht über lichtempfindliche Schichten auf Planarisierungsschichten gibt beispielsweise Y. Onishi et al. in SPIE, Vol. 539, Advances in Resist Technology and Processing II, S. 62.

Die Plasmaätzbeständigkeit von Bindemitteln, insbesondere die Beständigkeit gegenüber Sauerstoff-Plasmen, kann durch den Einbau von Metallatomen (z.B. Si, Ge, Sn, Ti) erzielt werden. In der Praxis hat sich die Verwendung von Silicium bewährt: Siliciumhaltige Verbindungen sind synthetisch vergleichsweise gut zugänglich, besitzen i.a. eine niedrige Toxizität und stellen keine Kontaminationsquelle bei Prozessen zur Fertigung von mikroelektronischen Schaltkreisen dar. Bisher bekannte siliciumhaltige Bindemittel weisen an herkömmliche Bindemittel gebundene Polysiloxangruppen auf (US-A-4,481,049).

Bindemittel dieser Art weisen aber eine zu niedrige Glastemperatur auf, so daß ein Fließen der Resiststrukturen unter thermischer Belastung, wie sie beispielsweise bei Plasmaätzprozessen auftreten kann, und als Folge daraus ein Verlust an Maßhaltigkeit, nicht verhindert werden kann; sie sind aber auch unverträglich mit anderen Bindemitteln, insbesondere mit alkalilöslichen Bindemitteln. Außerdem ist nachteilig ihre niedrige lithographische Empfindlichkeit und die Beschränkung auf Bestrahlungswellenlängen im tiefen UV-Licht.

Ein Polysiloxan, das Disilan-Einheiten enthält, wird von M. Ishikawa et al. in J. Polym. Sci. 21, S. 657 (1983) beschrieben. Neben der bekannten niedrigen Glastemperatur von Si-O-Si-Gruppen enthaltenden Polymeren kommt im Falle dieser Verbindung noch eine aufwendige Synthese der zu diesen Verbindungen notwendigen siliciumhaltigen Monomeren hinzu.

Weiterhin sind Polymere mit Polysilangruppen als Bestandteil der Hauptkette bekannt, die zwei bis sechs miteinander verbundene Si-Atome enthalten (EP-A-0 129 834, JP-A-153931/1983, JP-A-061831/1984, JP-A-008839/1985, JP-A-118745/1986, JP-A-189533/1986 und JP-A-025744/1987). Verbindungen dieser Art sind zwar gegenüber dem reaktiven Sauerstoff-Ionenätzen resistent, sie sind aber gleichzeitig gegenüber tiefem UV-Licht als Chromophor wirkam, d.h. durch Licht dieser Wellenlängen spaltbar. Darin liegt auch ihr Nachteil für die Anwendung in lichtempfindlichen Mischungen: Die Bestrahlungswellenlängen sind auf den tiefen UV-Bereich beschränkt und damit bei den heutigen zur Massenproduktion benutzten I- und H-line Belichtungsgeräten nicht anwendbar. Ein weiterer Nachteil liegt in der Schwierigkeit der Synthese dieser Verbindungen, weil Alkalimetalle in hochreaktiver Form verwendet werden müssen. Gleichzeitig ist nicht ohne weiteres gewährleistet, daß Polymere entstehen, die in wäßrigem Alkali löslich sind. Dies würde eine Lösemittelentwicklung nach sich ziehen, was aber gemäß den Auflagen des Umweltschutzes nicht in Betracht zu ziehen ist. Zudem ist ihre Verträglichkeit mit Kresol-Formaldehyd-Novolak-Harzen nicht gegeben, da Mischungen dieser Komponenten sich sofort entmischen, bevor sich ein gleichmäßiger Film auf den Träger (Substrat) bzw. auf der Planarisierungsschicht ausbilden kann.

Bindemittel für lichtempfindliche Mischungen, die Monosilangruppen ($-SiR_3$) enthalten, werden in EP-A-0 096 596 beschrieben. Nachteile der Verbindungen dieses Typs sind u.a. eine komplizierte Monomer- und

auch Polymersynthese. Durch Einführung nur eines Silicium-Atoms pro Monomer-Einheit wird der minimal für eine entsprechende Plasmaätzbeständigkeit zu fordernde Siliciumgehalt der Bindemitteln, wenn überhaupt, nur sehr schwer erreicht werden können. Ein gravierender Nachteil ist, daß diese Bindemittel lediglich eine Bilddifferenzierung aufgrund einer Entwicklung mit organischen Lösemitteln zulassen.

Die DE-A-22 17 744 beschreibt polymere Bindemittel, ebenso mit $SiR_3$-Gruppen, hier aber entstanden durch eine polymeranaloge Umsetzung von polymeren Bindemitteln mit reaktiven siliciumhaltigen Verbindungen oder durch Copolymerisation. Ob diese Verbindungen plasmaätzbeständig sind, ist dieser Schrift nicht zu entnehmen, sie sollen eine Verbesserung der Haftung auf Substraten herbeiführen. Nachweislich ist aber wegen der chemischen Reaktionsfähigkeit von Si-X-Bindungen die Lagerfähigkeit dieser Verbindungen sehr begrenzt, u.U. ist eine Nachvernetzung möglich.

Methylenverbrückte Si-Fragmente tragende Bindemittel werden als Bestandteil von Resistsystemen in JP-A-177005/1987 beschrieben. Diese sind aber nur über eine mehrstufige und aufwendige Synthese herstellbar.

Si-haltige Bindemittel, bei denen die phenolischen Hydroxylfunktionen über Ester- bzw. Iminoester-Funktionen mit Silicium verknüpft sind, werden in der JP-A-264342/1986 beschrieben. Ein Nachteil ist aber, daß die beschriebenen Silicium-Ester bzw. Silicium-Iminoester-Einheiten bei der zur Photolyse der zugesetzten Naphthochinondiazide bzw. Benzochinondiazide verwendeten Wellenlängen ebenfalls zersetzlich sind und abgespalten werden. Ein weiterer Nachteil der angeführten Verbindungen ist deren chemische Labilität gegenüber beispielsweise hydrolytischer Zersetzung, was sich ungünstig auf die Lagerstabilität auswirkt. Weiterhin nachteilig ist die schwierig reproduzierbare und mit niedrigen Gesamtausbeuten ablaufende mehrstufige Synthese der angeführten Verbindungen.

Bindemittel, denen Monomere, die Disilanyl-Einheiten enthalten, zugemischt werden, um dem betreffenden Wirtspolymeren Plasmatzbeständigkeit zu verleihen, werden in den US-A-4,481,279 und 4,464,455, sowie ähnliche Verbindungen in der JP-A-125729/1984, 125730/1984 und 121042/1984 beschrieben. Die dem Bindemittel zugemischten Disilanylverbindungen werden durch ionisierende Strahlung in der Polymermatrix verankert. Vor dem Entwicklungsschritt durch das reaktive Ionenätzen mit Sauerstoff wird das Disilan aus dem nichtbelichteten Bereich beispielsweise mit Hilfe eines Vakuumverfahrens entfernt. Die Nachteile des Verfahrens sind u.a., daß die bildmäßige Differenzierung unbefriedigend ist, weil in den unbelichteten Bereichen noch siliciumhaltige Monomere vorhanden sind und diese auch durch das obengenannte Vakuumverfahren nur ungenügend entfernt werden können.

Es bestand daher die Aufgabe, Silylierungsreagenzien vorzuschlagen, mit denen in wäßrigem Alkali lösliche Bindemittel in der Weise modifiziert werden können, daß sie eine ausreichende Plasmaätzbeständigkeit gegenüber dem reaktiven Ionenätzen, insbesondere mit Sauerstoff, aufzuweisen, das Bindemittel auch nach der Modifizierung in wäßrigem Alkali noch löslich ist, d.h. wäßrig entwickelbar ist, sowie das Bindemittel hydrolytisch oder sonst chemisch nicht abbaubar ist, so daß eine hohe Lagerbeständigkeit gewährleistet ist, sowie die Voraussetzung einer Belichtung mit den heutigen Belichtungsgeräten möglich ist, ohne einen durch diese Strahlung ausgelösten Abbau des Polymeren einzuleiten, und die Verbindungen nicht flüchtig sind. Außerdem sollen sowohl die Monomere wie auch mit diesen Monomeren letztendlich modifizierten Bindemittel leicht herstellbar sein.

Gelöst wird die Aufgabe durch Bereitstellen eines Silylierungsreagenzes als Monomeres der allgemeinen Formel I

$(A - B_n)_m C$ (I)

worin

A eine Silanylgruppe mit mindestens 2 miteinander verknüpften Siliciumatomen insgesamt, aber nicht mehr als 3 miteinander verknüpf-ten Siliciumatomen einer unverzweigten Kette aus Siliciumatomen,

B eine Brückengruppe und

C eine funktionelle Gruppe, die in der Lage ist, mit aromatischen und/oder aliphatischen bzw. cycloaliphatischen Hydroxylgruppen eine kovalente Bindung zu knüpfen, sowie

n 0 oder 1 und

m 1 oder 2

bedeuten.

Die mit den erfindungsgemäßen Silylierungsreagenzien hergestellten Bindemittel sind gegenüber Strahlung einer Wellenlänge von größer als 300 nm beständig.

Die Bindemittel enthalten die den Silylierungsreagenzien der allgemeinen Formel I zugrundeliegenden Silanylgruppen in der Seitenkette. Die Umschreibung "Seitenkette" bedeutet, daß die Silanylgruppen nicht Bestandteil der Polymerhauptkette des Bindemittels sind; dies wäre auch in Anbetracht der Methode zur Einführung dieser Gruppen in das Bindemittel nicht möglich, da das Bindemittel schon vor der Einführung der Silanylgruppen ein Polymeres ist.

Als Gruppe A werden Silanylgruppen folgender allgemeiner Formel II genannt

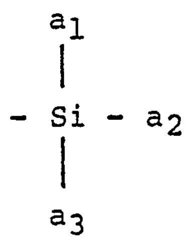

(II)

worin

$a_1$, $a_2$,$a_3$ R, $-SiR_3$ und $-Si_2R_5$ bedeuten, mit der Maßgabe, daß mindestens einer der Reste $-SiR_3$ und nicht mehr als ein Rest $-Si_2R_5$ bedeutet, wobei

R ($C_1$-$C_3$)Alkyl, insbesondere Methyl und/oder Aryl, insbesondere Phenyl,

bedeuten.

Insbesondere sind diejenigen Silanylgruppen bevorzugt, die zwei, drei oder vier Siliciumatome enthalten und/oder die als Rest R ($C_1$-$C_3$)Alkyl, insbesondere Methyl, aufweisen.

Besonders bevorzugt sind folgende Silanylgruppen: $-SiR(SiR_3)_2$, $-Si(SiR_3)_3$ und $-(SiR_2)_2-SiR_3$.

Als Gruppe B werden Brückengruppen der allgemeinen Formel III verstanden,

$-(b_1)_r-(X)-(b_2)_s-$ (III) worin

$b_1$ ($C_1$-$C_4$)Alkylen, insbesondere $C_2$-Alkylen, einer aus einem Alkdienylen, insbesondere einem Cycloalkdienylen mit insgesamt min-destens 4 C-Atomen, insbesondere Cyclopentadienyl, mit einem Dienophil in einer 1,4-Cycloaddition (Diels-Alder-Reaktion) entstehenden Gruppe, die mindestens eine C-C-Doppelbindung aufweist,

X eine Einfachbindung, -O-, -S-, $-SO_2-$, -NH-,

$-NR^1-$,

$-O-\overset{\overset{O}{\|}}{C}-$, $-\overset{\overset{H}{|}}{N}-\overset{\overset{O}{\|}}{C}-$ oder $-\overset{\overset{H}{|}}{N}-\overset{\overset{O}{\|}}{C}-O-$, worin $R^1$ ein ($C_1$-$C_3$)Alkyl ist,

$b_2$ Arylen, insbesondere Naphthylen und Phenylen, ggf. substituiert durch ($C_1$-$C_3$)Alkyl, ($C_1$-$C_3$) Alkoxy, insbesondere durch Methyl und in ortho-Position zu der Bindung, die die funktionelle Gruppe trägt, oder Cycloalkylen, insbesondere Cyclohexalkylen sowie

r, s O oder 1, mit der Maßgabe, daß die Summe aus den Werten von r und s mindestens 1 ist, bedeuten.

Sofern $b_2$ entsprechend den obigen Angaben ausgestaltet ist und X eine Einfachbindung darstellt, ist $b_1$ eine Alkylengruppe mit 2 oder mehr C-Atomen, insbesondere eine $C_2$-Alkylengruppe. Bevorzugt ist $b_1$ an Gruppe A gebunden.

Als Gruppe C werden funktionelle Gruppen genannt, wie Thiol, Hydroxyl, Amino, Epoxy, ggf. gebunden über eine Alkylen-, insbesondere Methylenoxagruppe, sowie Aziridino und Carboxyl, deren Derivate wie Ester, Anhydride, Chloride, Amide sowie Lactone und Lactame, aber auch Isocyanat und Carbodiimid.

Insbesondere bevorzugt sind diejenigen funktionellen Gruppen, die in einer Reaktion mit Hydroxylgruppen der Bindemittel durch Addition reagieren und von diesen wiederum diejenigen, bei denen sich während der Additionsreaktion keine Aminogruppen bilden.

Fast alle funktionellen Gruppen C sind monovalent, d.h. die Gruppen A und B sind einmal im Silylierungsreagenz der allgemeinen Formel I enthalten ($m = 1$ und $n = 1$). Ist $m = 2$ und $n = 1$, handelt es sich um eine bivalente funktionelle Gruppe C, z.B. ein Carbodiimid.

Insbesondere, wenn Lactone oder Lactame als funktionelle Gruppen C verwendet werden, gilt $n = 0$ ($m = 1$). Von den Lactonen und Lactamen sind die $\gamma$-Lactone bzw. -Lactame, die $\delta$-Lactone bzw. -Lactame und die $\beta$-Lactone bzw. -Lactame zu nennen. Insbesondere werden die entsprechenden Lactone bevorzugt.

Von den Anhydriden werden insbesondere cyclische Anhydride bevorzugt, da diese im Gegensatz zu den offenkettigen Verbindungen nach einem Additionsschema reagieren und keine Substitutionsreaktion einleiten. Ganz besonders bevorzugt ist die Maleinsäureanhydridgruppe. Die Anhydride können weiterhin ggf., sofern sie ein Dienophil sind, in einer 1,4-Cycloaddition (Diels-Alder-Reaktion) über eine entsprechende Brückengruppe B mit der Silanylgruppe A verbunden werden. Die Anhydridgruppe kann aber auch mit einem zur Cycloaddition befähigten Dienfragment verbunden sein.

Von den bevorzugten funktionellen Gruppen C ist weiterhin die Epoxygruppe zu nennen, die sowohl über $b_1$, sofern $s = 0$ ist und X entweder eine weniger bevorzugte Einfachbindung oder eine

$-\overset{H}{\underset{|}{N}}-\overset{O}{\underset{\|}{C}}-$-Gruppe ist, als auch über $b_2$, sofern $s=1$, X bevorzugt eine Einfachbindung und $b_2$ Phenylen ist, mit der Silanylgruppe verbunden.

Auch die Isocyanat-Gruppe ist bevorzugt. Sie ist besonders bevorzugt mit $b_1$, sofern $s=0$, als auch mit $b_2$, sofern

$X = -O-\overset{O}{\overset{\|}{C}}-\overset{H}{\overset{|}{N}}-$ ist, mit der Silanylgruppe verbunden.

Die ebenso als funktionelle Gruppen C genannten Carbodiimide gelten für $m=2$ und $n=1$. Diese werden durch Reaktion von zwei Isocyanatgruppen miteinander unter Abspaltung von $CO_2$ gewonnen. Infolgedessen gelten alle Anmerkungen, die über die Isocyanatgruppen gemacht werden, auch für die Carbodiimidgruppen, die bevorzugt über Brückenglied $b_1$, sofern $s=0$ ist und X eine Einfachbindung darstellt, an die Silanylgruppe gebunden sind.

Grundsätzlich sind aber Silylierungsreagenzen, die Isocyanatgruppen aufweisen, denjenigen, die Carbodiimidgruppen enthalten, vorzuziehen, da erstere gegenüber hydrolytischem Angriff beständigere Produkte ergeben.

Die Herstellung von Verbindungen, die Isocyanatgruppen enthalten, wird von S. Patai, The Chemistry of Cyanates and their Thio Derivatives, Part 2, Seite 619 ff beschrieben. Dort werden auch die funktionellen Gruppen beschrieben, die grundsätzlich in der Lage sind, mit dieser Gruppe zu reagieren, insbesondere in eine Additionsreaktion einzutreten.

Weiterhin sind dem Fachmann eine Vielzahl von funktionellen Gruppen bekannt, die eine konvalente Verknüpfung zwischen Silylierungsreagenz und Bindemittel ermöglichen. Solche Gruppen werden beispielsweise von H.A. Staab in Angew. Chem. 74, 407 (1962) beschrieben.

Darüber hinaus sind als funktionelle Gruppen auch solche geeignet, die z.B. aus der Peptid-Chemie bekannt sind und beispielsweise von K. Takeda, K. Tsuboyama, K. Yamaguchi und H. Ogura in J. Org. Chem. 50, 273 (1985) oder von T. Mukaiyama, M. Usui, E. Shimada und K. Saigo in Chem. Lett. 741 (1975) bekannt sind.

Diese werden aber nicht bevorzugt, da sie bei der Knüpfung der kovalenten Bindung zwischen den Silylierungsreagenz und der Hydroxygruppe des Bindemittels unter Substitution reagieren.

Die erfindungsgemäß beanspruchten Silylierungsreagenzien sind gegenüber UV-Strahlung beständig, insbesondere im Bereich einer Wellenlänge größer als 300 nm, bevorzugte Vertreter sind folgende Verbindungen: 2-(Pentaalkyl- bzw. -aryl-disilanyl)-($C_1$-$C_4$)alkylisocyanate, 2- [Tris(trialkyl- bzw. -aryl-silyl)-silanyl]-($C_1$-$C_4$)alkylisocyanate, 2- [Bis(trialkyl- bzw. -aryl-silyl)silanylalkyl] -($C_1$-$C_4$)alkylisocyanate sowie 2-(Heptaalkyl- bzw. -aryl-trisilanyl)-($C_1$-$C_4$)alkylisocyanate. Unter den Vertretern dieser Monomere sind solche besonders bevorzugt, deren Silanylrest Alkylgruppen trägt, insbesondere Methyl. Als Bindeglied wird besonders bevorzugt in diesen Verbindungen die Ethylengruppe eingesetzt.

Bevorzugte Vertreter derjenigen Verbindungen, die als funktionelle Gruppen Epoxygruppen enthalten, sind:

4-(ω-Pentaalkyl- bzw. -aryl-disilanyl-($C_1$-$C_4$)alkyl)O-2,3-epoxypropyl-phenole, 4-[ω-Tris(trialkyl- bzw. -aryl-silyl)silanyl-($C_1$-$C_4$)alkyl -O-2,3-epoxypropylphenole, 4-[ω-Bis(trialkylsilyl)silanylalkyl-($C_1$-$C_4$)alkyl]-O-2,3-expoxypropyl-phenole sowie 4-[ω-Heptaalkyltrisilanyl-($C_1$-$C_4$)alkyl)-O-2,3-expoxy-propyl-phenole. Genannt werden auch die entsprechenden Verbindungen, deren Silanylrest sich in Position 2 zu der O-2,3-Expoxpropylgruppe befindet. Der ($C_1$-$C_4$)Alkylrest, über den der Silanylrest sowohl in Position 2 wie auch bevorzugt in Position 4 gebunden ist, ist besonders bevorzugt mindestens ein $C_2$-Alkylrest, wobei $C_2$-Alkyl auch der bevorzugte Rest dieser Reihe darstellt. Der Silanylrest ist dann in Position 2 des $C_2$-Alkylrestes gebunden. Besonders bevorzugt sind bei dieser Verbindungsklasse auch diejenigen Verbindungen, bei denen die Alkylgruppen im jeweiligen Silanylrest vorhanden sind und insbesondere Methyl entsprechen. Die aromatische Einheit in der Brückengruppe der hier beschriebenen Verbindungen kann auch substituiert sein durch Alkyl und Alkoxy. Bevorzugt ist diese Ausführungsform aber nicht.

Bevorzugte Vertreter von Diels-Alder-Produkten sind:

(2,3)-endo-7-anti-Pentaalkyl- bzw. -aryl-disilanyl-bicyclo [2.2.1] hept-5-en-2,3-dicarbonsäureanhydrid, (2,3)-endo-7-anti-Tris(trialkyl- bzw. -aryl-silyl)silanyl-bicyclo [2.2.1] hept-5-en-2,3-dicarbonsäureanhydrid, (2,3)-endo-7-anti-Bis(trialkyl- bzw. -aryl-silyl)-silanylalkyl-bicyclo [2.2.1] hept-5-en-2,3-dicarbonsäureanhydrid, (2,3)endo-7-anti-Heptaalkyl- bzw. -aryltrisilanyl-bicyclo [2.2.1] hept-5-en-2,3-dicarbonsäureanhydrid. Besonders bevorzugt sind Verbindungen, bei denen Alkylgruppen in dem jeweiligen Silanylrest vorhanden sind und Methyl darstellen.

Von den Lactamen bzw. Lactonen werden folgende Verbindungen bevorzugt:

3-Pentaalkyl- bzw. -aryl-disilanyl-lactone und -lactame, Tris(trialkyl- bzw. -aryl-silyl)silanyl-lactone und -lactame, Bis(trialkyl- bzw. -aryl-silyl)silanylalkyllactone und -lactame, sowie Heptaalkyltrisilanyllactone und

-lactame. Besonders bevorzugt sind die Verbindungen, bei denen Alkylgruppen in den jeweiligen Silanylresten vorhanden sind und Methyl darstellen.

Lactone sind besonders bevorzugt, insbesondere $\beta$-Propiolactone, $\beta$- und $\gamma$-Butyrolactone, $\beta$-, $\gamma$- und $\delta$-Valerolactone, $\gamma$- und $\delta$-Caprolactone.

Von den Silylierungsreagenzien, die Carbodiimid als funktionelle Gruppe aufweisen, sind alle die Verbindungen zu nennen, die auch Isocyanatgruppen aufweisen können. Im Vergleich zu diesen sind aber die Verbindungen mit Carbodiimid weniger bevorzugt.

Weiterhin sind Silylierungsreagenzien bevorzugt, deren Brückengruppe Carbaminsäureeinheiten als X enthalten. Die eigentlichen funktionellen Gruppen können als an diesen Einheiten direkt esterartig gebunden sein, die Einheiten können aber auch als verbindendes Glied in der Brückengruppe fungieren, d.h. mit den funktionellen Gruppen nicht direkt verbunden sein.

Als Beispiele sind zu nennen:

N-$\omega$-(Pentaalkyl- bzw. -aryl-disilanyl)-($C_1$-$C_4$)alkyl-O-2,3-epoxypropyl-carbaminsäuren, N-$\omega$-(Tristrialkyl-bzw. -aryl-silylsilanyl)-($C_1$-$C_4$)alkyl-O-2,3-epoxypropylcarbaminsäuren, N-$\omega$-(Bistrialkyl- bzw. aryl-silylsilanylalkyl)-($C_1$-$C_4$)alkyl-O-2,3-epoxypropylcarbaminsäuren, N-$\omega$-(Heptalkyl- bzw. -aryl-trisilanyl)-($C_1$-$C_4$)-alkyl-O-2,3-epoxypropylcarbaminsäuren.

Von diesen wiederum sind diejenigen bevorzugt, die Alkylgruppen aufweisen und insbesondere Methyl bedeuten. Von den Brückeneinheiten ($C_1$-$C_4$)Alkylen sind wiederum die mit $C_2$-Alkylen bevorzugt, so daß die Position "$\omega$" als Position 2 präzisiert werden kann. Neben diesen werden besonders bevorzugt:N-Isocyantophenyl-O-($\omega$-silanyl)-($C_1$-$C_4$)alkylcarbaminsäuren, wobei als Silanyl, wie in den vorherigen Beispielen jeweils Pentaalkyldisilanyl, Tristrialkylsilylsilanyl, Bistrialkylsilylalkylsilanyl und Heptaalkyltrisila nyl, sowie auch die entsprechenden Arylsilanyle zu verstehen sind.

Als ($C_1$-$C_4$)Alkylreste werden wiederum diejenigen mit $C_2$-Alkylen bevorzugt, so daß die Position "$\omega$" als Position 2 präzisiert werden kann. Ganz besonders bevorzugt sind Verbindungen dieses Typs, die die Isocyanatgruppen in Position 4 des Phenylrestes tragen, worunter wiederum diejenigen besonders eingesetzt werden, deren Phenylrest zusätzlich in Position 3 durch Alkyl, insbesondere durch Methyl substituiert ist. Die Alkylsubstituenten der Silanylgruppen sind bevorzugt Methyl.

Die diesen Silylierungsreagenzien zugrunde liegende Silanylverbindungen, müssen, um mit den beschriebenen Brückengruppen reagieren zu können, halogeniert, insbesondere chloriert sein. Gemische von Verbindungen dieses Typs fallen als Nebenprodukt der sogenannten Direktsynthese, wie sie beispielsweise von R. Schliebs und J. Ackermann in Chem. i. u. Zt. 21, 121 (1987) beschrieben wird, in technischen Mengen an. Weiterhin lassen sich Verbindungen dieses Typs gezielt in guten Ausbeuten ausgehend von einfachsten Siliziumverbindungen synthetisieren. Dazu findet man ausführliche Angaben beispielsweise in folgenden Schriften: M. Kumada, K. Tamao in Adv. Organomet. Chem. 6, 19 (1968) und E. Hengge in Topics in Current Chemistry 51, 1 (1974).

Bindemittel, die die erfindungsgemäß beanspruchten Silanylgruppen in den Seitenketten tragen, weisen alle die aufgabengemäß gewünschten Eigenschaften auf. Hierbei sind insbesondere zu nennen:

- Sie sind in einfacher Weise in hoher Reinheit und guten Ausbeuten herzustellen und weisen
- eine ausreichende Löslichkeit in wäßrigem Alkali, - eine sehr hohe Plasmaätzbeständigkeit, z.B. beim reaktiven Ionenätzen mit Sauerstoff,
- eine überraschend hohe Lagerstabilität sowie
- eine hohe Beständigkeit gegenüber Strahlung, mit der heutzutage die bildmäßige Belichtung von lichtempfindlichen Gemischen vorgenommen werden kann (I- und H-Line Belichtungsgeräte, Wellenlänge größer als 300 nm) und mit der nach dem bisherigen Stand der Technik nicht gerechnet werden konnte.

Die folgenden Beispiele sollen die Erfindung verdeutlichen. Die zum Vergleich hergestellten, lediglich Monosilangruppen aufweisenden Bindemittel weisen die Vorteile, die mit den erfindungsgemäß hergestellten Monomeren erzielbar sind, nicht auf. Insbesondere weisen die Bindemittel, die Monosilangruppen enthalten, im Vergleich zu denen, die mit den erfindungsgemäßen Silylierungsreagenzien umgesetzt werden, unter der Voraussetzung, daß in beiden Fällen die Molverhältnisse der Umsetzungsedukte gleich sind, und im Falle der erfindungsgemäßen Bindemittel gerade eine hinreichende Plasmaätzbeständigkeit erreicht wird, keine hinreichende Plasmaätzbeständigkeit auf.

Beispiel 1: Darstellung von 2-(Pentamethyldisilanyl)-ethyl-isocyanat

In einem 250 ml Zweihalskolben, ausgestattet mit Gaseinleitungsrohr und Rückflußkühler, suspendiert man 50 g 2-(Pentamethyldisilanyl)-ethylamin-Hydrochlorid in 100 ml trockenem Toluol. Dann leitet man unter Rühren einen kräftigen Strom gasförmiges Phosgen durch die Lösung und erwärmt dabei bis zum

Sieden. Die Umsetzung des Hydrochlorids zum Isocyanats ist dann beendet, wenn eine klare Toluol-Lösung entstanden ist. Anschließend destilliert man das überschüssige Toluol im Wasserstrahlvakuum ab und fraktioniert den verbleibenden Rückstand im Ölpumpenvakuum.

Die Ausbeute beträgt 42 g (95 % der Theorie), der Siedepunkt wird zu 48° C/0,1 mmHg bestimmt.

Die Reinheit wurde durch gaschromatische Analyse bestimmt und beträgt > 99 %.

Ein $^{13}C$-NMR-Spektrum (22,5 MHz, $CDCl_3$ als Lösemittel und Referenz) erbrachte folgende Signale (siehe FIG 1):

$\delta$ = 122,8 ppm (-NCO),
$\delta$ = 40,2 ppm ($N-CH_2-$),
$\delta$ = 18,8 ppm ($Si-CH_2-$)
$\delta$ = -2,3 ppm ($SiMe_3$)
$\delta$ = -4,5 ppm ($-SiMe_2-$).

Das Edukt, 2-(Pentamethyldisilanyl)-ethylamin-Hydro chlorid, wird wie folgt dargestellt:

In einem 250 ml Dreihalskolben läßt man unter einer Argon-Atmosphäre zu 4,2 g Lithiumaluminumhydrid in 50 ml Diethylether eine Lösung von 14,7 g Aluminiumtrichlorid (wasserfrei) in 50 ml Diethylether innerhalb 10 min zutropfen. Anschließend läßt man noch 30 min rühren und tropft dann innerhalb 1 h 15,4 g Pentamethyldisilanyl-acetonitril zu und erhitzt die Lösung 1 h am Rückfluß.

Anschließend wird unter Eiskühlung vorsichtig tropfenweise mit 100 ml 20%iger Salzsäure hydrolysiert. Dabei fällt das Hydrochlorid als farblose Kristallmasse aus. Die Kristalle werden abgesaugt, im Vakuum getrocknet und aus wenig Tetrahydrofuran umkristallisiert. Die Ausbeute beträgt nach dem Umkristallisieren 56 %.

Ein $^{13}C$-NMR Spektrum (22,5 MHz, $CDCl_3$ als Lösemittel und Referenz) erbrachte folgende Signale:

$\delta$ = 37,6 ppm ($N-CH_2-$),
$\delta$ = 14,3 ppm ($Si-CH_2-$),
$\delta$ = -2,3 ppm ($-SiMe_3$),
$\delta$ = -4,6 ppm ($-SiMe_2-$)

Die Ausgangsverbindung hierzu, das Pentamethyldisilanyl-acetonitril, kann nach einer Vorschrift von M. Kumada et al. in J. Organomet. Chem. 5, 226 (1966) hergestellt werden.

Beispiel 2: Darstellung von Tris(trimethylsilyl)silanyl $\beta$-ethylisocyanat

Die Verbindung wird analog zu dem in Beispiel 1 beschriebenen Verfahren aus Tris(trimethylsilyl)-silanyl-$\beta$-ethylamin-Hydrochlorid hergestellt.

Die destillative Reinigung des Rohprodukts im Hochvakuum mit Hilfe einer Kugelrohrapparatur liefert farblose Kristalle.

Ein $^{13}C$-NMR-Spektrum (22,5 MHz, $CDCl_3$ als Lösemittel und Referenz) zeigte folgende Signale (siehe FIG 2):

$\delta$ = 122,7 ppm (-N=C=O)
$\delta$ = 43,1 ppm ($-CH_2-NCO$)
$\delta$ = 12,5 ppm ($Si-CH_2-$)
$\delta$ = 1,2 ppm ($-SiMe_3$)

Die Elementaranalyse ergibt:

| | | | |
|---|---|---|---|
| Ber.: | C = 45,36 ; | H = 9,93 ; | N = 4,41 |
| Gef.: | C = 45,2 ; | H = 9,9 ; | N = 4,6 |

Das Edukt hierzu, das Tris(trimethylsilyl)silanyl-$\beta$-ethylamin-Hydrochlorid, kann nach zwei Methoden hergestellt werden:

1) In einem 100 ml Kolben wird unter Argon-Atmosphäre zu 0,28 g Lithium-Schnitzel in 50 ml trockenem Diethylether 4,4 g 2,2,5,5-Tetramethyl-1-aza-2,5-di silacyclopentanyl-ethylchlorid in 20 ml Diethylether im Verlauf von 2 h zugetropft. Anschließend läßt man noch 4 h bei Raumtemperatur rühren und gibt dann 5,7 g Tris-(trimethylsilyl)chlorsilan in einer Portion zu. Man läßt die Reaktionslösung über Nacht stehen und versetzt dann tropfenweise unter Eiskühlung mit 30 ml 20%iger Salzsäure. Das entstehende

Hydrochlorid scheidet sich als farblose Kristallmasse ab. Die Kristalle werden abgesaugt und aus Toluol umkristallisiert.

Tris-(trimethylsilyl)chlorsilan kann nach einer Vorschrift von H. Bürger, W. Kilian und K. Burczyk in J. Organomet. Chem. 21, S. 291 (1970) hergestellt werden.

2,2,5,5-Tetramethyl-1-aza-2,5-disilacyclopentan-1-ylethylchlorid wird nach einem von F.Z. Basha und J.F. DeBernardis in Tetrahedron Lett., S. 5271 (1984) vorgeschlagenen Verfahren aus 1,2-Bis-(chlordimethylsilyl)-ethan und 2-Chlorethylamin-Hydrochlorid hergestellt.

2) Das Edukt, Tris(trimethylsilyl)silanylacetonitril, wird nach einem modifizierten Verfahren gemäß den Angaben von I. Matsuda, S. Murata und Y. Ishii in J. Chem. Soc. Perkin I, S. 26 (1979) aus Tris-(trimethylsilyl)chlorsilan und Chloracetonitril gewonnen:
In einem 250 ml Dreihalskolben ausgestattet mit In nenthermometer, Tropftrichter, Schutzgaseinleitung und Magnetrührer legt man unter Argon-Schutzgasatmosphäre eine Suspension von 7,2 g Zinkstaub in 100 ml N-Methylpyrrolidon vor. Zu der gut gerührten Suspension tropft man im Verlauf einer Stunde eine Mischung bestehend aus 7,6 g Chloracetonitril, 28,3 g Tris(trimethylsilyl)chlorsilan und 50 ml N-Methylpyrrolidon so zu, daß die Innentemperatur 60° C nicht übersteigt. Anschließend thermostatisiert man die Lösung bei 60° C für 18 h. Zur Aufarbeitung gießt man die abgekühlte Lösung unter Rühren in 500 ml Eiswasser. Die ausgefallene farblose Kri stallmasse wird abgesaugt und im Vakuum getrocknet. Die Ausbeute beträgt 22 g (76 % der Theorie).

Eine analysenreine Probe wird durch Sublimation bei 100° C im Ölpumpenvakuum erhalten.

Tris(trimethylsilyl)silanylacetonitril wird durch das in Beispiel 1 beschriebene Verfahren zum Amin-Hydrochlorid reduziert.

Ein $^{13}$C-NMR-Spektrum von Tris(trimethylsilyl)silanyl-$\beta$-ethylamin-Hydrochlorid (22,5 MHz, $CDCl_3$ als Lösemittel und Referenz) zeigte folgende Signale:

$\delta$ = 39,9 ($-CH_2-N$)
$\delta$ = 7,2 ($-CH_2-Si$)
$\delta$ = 1,1 ($-SiMe_3$)

Die Elementaranalyse ergibt:

| | | | |
|---|---|---|---|
| Ber.: | C = 40,35 ; | H = 10,44 ; | N = 4,27 |
| Gef.: | C = 39,9 ; | H = 10,5 ; | N = 4,1 |

Beispiel 3: Darstellung von 4-(2-Pentamethyldisilanylethyl)-O-2,3-epoxypropyl-phenol

In einem 100 ml Kolben wird eine Mischung aus 5,0 g 4-(2-Pentamethyldisilanyl-ethyl)phenol, 1,8 g Epichlorhydrin, 0,5 g Kaliumjodid und 5 g Kaliumcarbonat 8 h unter Rühren am Rückfluß erhitzt. Anschließend filtriert man vom ausgefallenen Salz und überschüssigem Kaliumcarbonat ab und engt die Lösung am Rotationsverdampfer ein. Der ölige Rückstand wird mit einem Kugelrohrapparat destilliert. Man erhält das Produkt in 42 % Ausbeute.

Ein $^{13}$C-NMR Spektrum (22,5 MHz, $CDCl_3$ als Lösemittel und Referenz) ergab folgende Signale:

$\delta$ = 156,3, 137,7, 128,4, 114,4 ppm (Aromat)
$\delta$ = 68,5 ppm ($O-CH_2-$)

$\delta$ = 50,0, 44,2 ppm 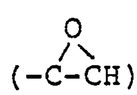

$\delta$ = 29,6, 17,0 ppm ($-CH_2-CH_2-$)
$\delta$ = -2,2 ppm ($-SiMe_3$)
$\delta$ = -4,5 ppm ($-SiMe_2-$).

Das Edukt, 4-(2-Pentamethyldisilanyl-ethyl)phenol, wird wie folgt dargestellt:

In einem 1.000 ml Dreihalskolben, ausgestattet mit Rückflußkühler, Tropftrichter und Innenthermometer, werden 500 ml trockenes Tetrahydrofuran und 12,4 g Magnesiumspäne nach Grignard unter Stickstoff-Atmosphäre vorgelegt. Dazu tropft man 10 g 4-(2-Brom-ethyl)-O-trimethylsilylphenol und anschließend 1 ml Ethylendibromid und erhitzt die Lösung unter Rühren auf 60° C. Den Reaktionsstart erkennt man an einem spontanen Aufsieden der Lösung auch ohne äußere Wärmezufuhr. Wenn die Reaktion gestartet ist, läßt

man 127 g 4-(2-Bromethyl)-O-trimethylsilylphenol so schnell zutropfen, daß die Lösung am Sieden bleibt. Anschließend erhitzt man noch 1 h am Rückfluß. Danach werden 83.4 ml Pentamethylchlordisilan innerhalb 0,5 h zugetropft und die Lösung anschließend 3 h am Rückfluß erhitzt. Danach versetzt man vorsichtig mit 300 ml 3 n HCl und engt am Rotationsverdampfer die Reaktionslösung soweit ein, bis 300 ml Tetrahydrofuran abdestilliert sind. Die sich abscheidende organische Phase wird abgetrennt und die wäßrige Phase mit 200 ml Diethylether extrahiert. Die vereinigten organischen Phasen werden mit 200 ml 10%iger Kochsalzlösung rückextrahiert und die organische Phase nach dem Abziehen am Rotationsverdampfer der Vakuumdestillation unterworfen.

Die Ausbeute beträgt: 61 % der Theorie.

Ein $^{13}$C-NMR Spektrum (22,5 MHz, $CDCl_3$ als Lösemittel und Referenz) erbrachte folgende Signale:

$\delta$ = 153,1 ppm (C-OH, Aromat)
$\delta$ = 137,6, 128,7, 115,3 ppm (Aromat)
$\delta$ = 29,8 ppm (Aromat-CH)
$\delta$ = 17,2 ppm ($CH_2$-Si)
$\delta$ = -2,0 ppm ($-SiMe_3$)
$\delta$ = -4,4 ppm ($-SiMe_2-$)

Das Edukt, 4-(2-Brom-ethyl)-O-trimethylsilylphenol, kann aus 4-($\beta$-Brom-ethyl)phenol durch Umsetzung mit Hexamethyldisilazan hergestellt werden.

Beispiel 4: Darstellung von (2,3)-endo-7-anti-Pentamethyldisilanyl-bicyclo [2.2.1] hept-5-en-2,3-dicarbonsäureanhydrid

In einem 100 ml Kolben werden 4,0 g Maleinsäureanhydrid in 50 ml Tetrahydrofuran gelöst. Zu dieser Lösung tropft man langsam unter Eiskühlung im Verlauf von 1 h 10 g 5-(Pentamethyldisilanyl)-cyclopentadien und läßt dann noch 6 h bei Raumtemperatur stehen. Anschließend wird das Lösemittel am Rotationsverdampfer entfernt und der Rückstand aus Cyclohexan umkristallisiert. Man erhält farblose Kristalle in 65 %iger Ausbeute mit einem Schmelzpunkt von 85° C.

Ein $^{13}$C-NMR Spektrum (22,5 MHz, $CDCl_3$ als Lösemittel und Referenz) erbrachte folgende Signale:

$\delta$ = 170,9 ppm (C=O)
$\delta$ = 135,0 ppm (C=C)
$\delta$ = 56,0, 49,1 ppm (C, cycloaliphatisch)
$\delta$ = -2,3, -3,3 ppm ($-SiMe_3$, $-SiMe_2-$)

Die Elementaranalyse zeigte Übereinstimmung zwischen den berechneten und gefundenen Werten.

| | | |
|---|---|---|
| Ber.: | C 57,1 % ; | H 7,5 % |
| Gef.: | C 57,4 % ; | H 7,6 % |

Das Edukt, 5-(Pentamethyldisilanyl)-cyclopentadien, kann nach einem von K.C. Frisch in J. Amer. Chem. 75, S.6050 (1953) angegebenen Verfahren aus Cyclopentadien und Pentamethyldichlordisilan hergestellt werden.

Beispiel 5: Darstellung von 2-Pentamethyldisilanyl-$\gamma$-butyrolacton

In einem 1.000 ml Dreihalskolben, ausgestattet mit Innenthermometer, KPG-Rührer und Tropftrichter, werden 200 ml N-Methylpyrrolidon und 34,3 g Zinkstaub vorgelegt. Unter Rühren tropft man eine Mischung aus 82,5 g 2-Brom-$\gamma$-butyrolacton und 83,4 g Pentamethylchlordisilan und 100 ml N-Methylpyrrolidon so zu, daß bei der exothermen Reaktion die Innentemperatur sich auf 60° C einstellt. Man läßt noch 6 h bei dieser Temperatur nachrühren und gießt dann den Reaktionsansatz auf 500 g Scherbeneis. Wenn das Eis aufgeschmolzen ist, wird die sich abscheidende organische Phase abgetrennt und die wäßrige Phase mit 200 ml Cyclohexan extrahiert. Die vereinigten organischen Phasen werden nach Trocknung über Magnesiumsulfat am Rotationsverdampfer abgezogen, und der Rückstand im Vakuum destilliert.

In analoger Weise wird das entsprechende 2-Pentamethyl disilanyl-$\beta$-propriolacton hergestellt.

Die Ausbeute beträgt 93 g, der Siedepunkt liegt bei 75° C/1 mmHg.

Ein $^{13}$C-NMR Spektrum (22,5 MHz, $CDCl_3$ als Lösemittel und Referenz) erbrachte folgende Signale:

δ = 179,0 ppm (C=O)
δ = 67,0, 27,6, 24,5 ppm (aliphatische Ring-Kohlenstoffatome)
δ = -2,6 ppm (-$SiMe_3$)
δ = -5,6 ppm (-$SiMe_2$-)

Beispiel 6: Darstellung von Bis-(2-Pentamethyldisilanylethyl)-carbodiimid

Die Darstellung dieser Verbindung erfolgt nach einem von T.W. Campbell, J.J. Monagle und V.S. Foldi in J. Amer. Chem. Soc. 84, S. 3673 (1962) beschriebenen Verfahren.

In einem 100 ml Kolben werden 20 g 2-(Pentamethyldisilanyl)ethylisocyanat und 100 mg 3-Methyl-1-phenyl-2,5-dihydro-phosphol-1-oxid in 50 ml Toluol unter Rühren auf 50° C erhitzt. Die einsetzende Kohlendioxid-Entwicklung kontrolliert man mit einem Blasenzähler. Nach 5 h hat die Kohlendioxidentwicklung nahezu aufgehört. Das Lösemittel wird im Wasserstrahlvakuum abdestilliert. Der verbleibende Rückstand besteht aus 95 % Carbodiimid und ist für die nachfolgend beschriebenen Umsetzungen ausreichend rein.

Das IR-Spektrum zeigt eine ausgeprägte Bande bei 2.140 $cm^{-1}$, die typisch für die asymmetrische N=C=N-Valenzschwingung von Carbodiimiden ist.

Beispiel 7: Darstellung von N-2-(Pentamethyldisilanyl) ethyl-O-2,3-epoxypropylcarbaminsäure

In einem 100 ml Kolben werden 10,5 g 2-(Pentamethyldisilanyl)-ethylisocyanat in 50 ml trockenem Diethylether unter Stickstoff-Atmosphäre vorgelegt und mit 3,7 g 2,3-Epoxy-1-propanol versetzt. Man läßt über Nacht bei Raumtemperatur stehen und zieht dann das Lösemittel am Rotationsdampfer ab. Der Rückstand besteht aus einem farblosen viskosen Öl, das für die in der gleichzeitig eingereichten Patentanmeldung Hoe 88/K beschriebenen Umsetzungen mit den Bindemitteln ausreichend rein ist.

Beispiel 8: Darstellung von N-(3-Methyl-4-isocyanato) phenyl-O-(2-pentamethyldisilanyl)ethyl-carbaminsäure

In einem 250 ml Zweihalskolben, ausgestattet mit Tropftrichter und Innenthermometer, werden 17,4 g Toluol-2,4-diisocyanat in 50 ml Tetrahydrofuran unter Stickstoff-Atmosphäre vorgelegt und dazu unter Eiskühlung im Verlauf von 2 h 17,5 g 2-(Pentamethyldisilanyl)ethanol in 50 ml Tetrahydrofuran zugetropft. Die Reaktion ist leicht exotherm und die Innentemperatur soll 20° C nicht überschreiten. Anschließend läßt man die Reaktionslösung noch 8 h bei Raumtemperatur rühren und zieht dann das Lösemittel am Rotationsverdampfer ab. Es verbleibt ein viskoser Rückstand, der für die in der gleichzeitig eingereichten Patentanmeldung Hoe 88/K 023 beschriebenen Umsetzungen ausreichend rein ist.

Das Edukt, 2-(Pentamethyldisilanyl)ethanol, kann nach einer Vorschrift von M. Kumada, N. Imaki und K. Yamamoto in J. Organomet. Chem. 6, S. 490 (1966) hergestellt werden.

Beispiel 9 (Vergleichsbeispiel): Darstellung 2-(Trimethylsilyl)ethylisocyanat

Die Verbindung wird analog zu dem in Beispiel 1 beschriebenen Verfahren hergestellt.

Ein $^{13}C$-NMR Spektrum (22,5 MHz, $CDCl_3$ als Lösemittel und Referenz) zeigte folgende Signale:
δ = 122,5 ppm (-N=C=O)
δ = 39,7 ppm (N-$CH_2$-)
δ = 20,3 ppm (Si-$CH_2$-)
δ = -1,9 ppm (-$SiMe_3$)

Das Edukt, 2-(Trimethylsilyl)ethylamin-Hydrochlorid, kann nach einer Vorschrift von L.H. Sommer und J. Rockett in J. Amer. Chem. Soc. 73, S. 5130 (1951) hergestellt werden.

Beispiel 10 (Vergleichsbeispiel): Darstellung von N-(3-Methyl-4-isocyanato)phenyl-O-(2-trimethylsilyl) ethyl-carbaminsäure

Die Darstellung der Verbindung erfolgt gemäß dem in Beispiel 8 beschriebenen Verfahren.

Man erhält eine farblose, viskose Flüssigkeit, die für die in der gleichzeitig eingereichten Patentanmeldung Hoe 88/K 023 beschriebenen Umsetzungen ausreichend rein ist.

Beispiel 11 (Vergleichsbeispiel): Darstellung von (2,3)-endo-7-anti-Trimethylsilyl-bicyclo [2.2.1] hept-5-en-2,3-dicarbonsäureanhydrid

Das Anhydrid kann nach einer Vorschrift von P. Magnus, P.M. Cairns und J. Moursounidis in J. Amer. Chem. Soc. 109, S. 2469 (1987) hergestellt werden.

Die erhaltenen Analysenwerte stimmen mit den in der zitierten Literatur angegebenen Werten überein.

| | |
|---|---|
| Produkt aus Herstellungsbeispiel 1 | 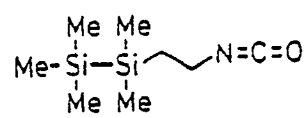 |
| Produkt aus Herstellungsbeispiel 2 | 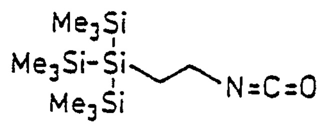 |
| Produkt aus Herstellungsbeispiel 3 | 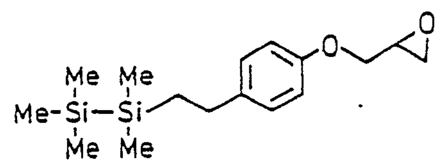 |
| Produkt aus Herstellungsbeispiel 4 | 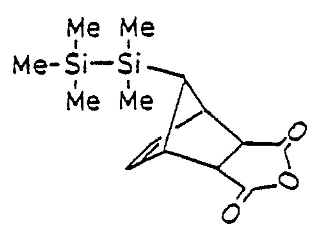 |
| Produkt aus Herstellungsbeispiel 5 | 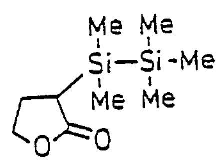 |

Me = Methyl

| | |
|---|---|
| Produkt aus Herstellungsbeispiel 6 | 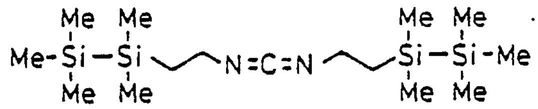 |
| Produkt aus Herstellungsbeispiel 7 | 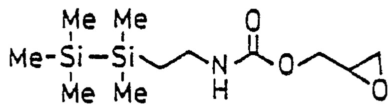 |
| Produkt aus Herstellungsbeispiel 8 | 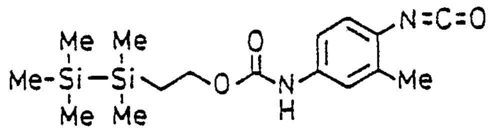 |
| | |
| Produkt aus Herstellungsbeispiel 9 | 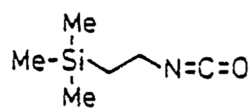 |
| Produkt aus Herstellungsbeispiel 10 | 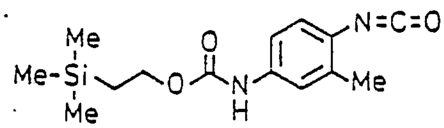 |
| Produkt aus Herstellungsbeispiel 11 | 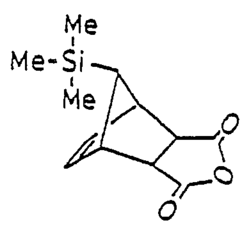 |

Me = Methyl

## Ansprüche

1. Silylierungsreagenz zur Herstellung von in wäßrigem Alkali löslichen, Silanylgruppen in der Seitenkette enthaltenden Bindemitteln, dadurch gekennzeichnet, daß das Reagenz der allgemeinen Formel I $(A - B_n)_m C$ (I)
entspricht, worin
A eine Silanylgruppe mit mindestens 2 miteinander verknüpften Siliciumatomen insgesamt, aber nicht mehr als 3 miteinander verknüpf-ten Siliciumatomen einer unverzweigten Kette aus Siliciumatomen,
B eine Brückengruppe und
C eine funktionelle Gruppe, die in der Lage ist, mit aromatischen und/oder aliphatischen bzw. cycloaliphatischen Hydroxylgruppen eine kovalente Bindung zu knüpfen, sowie

n 0 oder 1 und
m 1 oder 2
bedeuten.

2. Silylierungsreagenz nach Anspruch 1, dadurch gekennzeichnet, daß die Gruppe A der allgemeinen Formel II entspricht

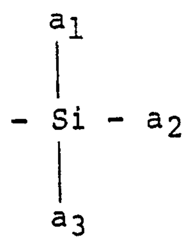

(II)

worin
$a_1$, $a_2$,$a_3$ R, $-SiR_3$ und $-Si_2R_5$ bedeuten, mit der Maßgabe, daß mindestens einer der Reste $-SiR_3$ und nicht mehr als ein Rest $-Si_2R_5$ bedeutet, wobei
R ($C_1$-$C_3$)Alkyl, insbesondere Methyl und/oder Aryl, insbesondere Phenyl,
bedeuten.

3. Silylierungsreagenz nach Anspruch 1, dadurch gekennzeichnet, daß die Gruppe B der allgemeinen Formel III entspricht
$-(b_1)_r - (X) - (b_2)_s-$ (III)
worin
$b_1$ ($C_1$-$C_4$)Alkylen, insbesondere $C_2$-Alkylen, einer aus einem Alkdienylen, insbesondere einem Cycloalkdienylen mit insgesamt mindestens 4 C-Atomen, insbesondere Cyclopentadienyl, mit einem Dienophil in einer 1,4-Cycloaddition (Diels-Alder-Reaktion) entstehen den Gruppe, die mindestens eine C-C-Doppelbindung aufweist,
X eine Einfachbindung, -O-, -S-, $-SO_2-$, -NH-, $-NR^1-$,
$-O-\overset{O}{\overset{\|}{C}}-$, $-\overset{H}{\overset{|}{N}}-\overset{O}{\overset{\|}{C}}-$ oder $-\overset{H}{\overset{|}{N}}-\overset{O}{\overset{\|}{C}}-O-$, worin $R^1$ ein ($C_1$-$C_3$)Alkyl ist,
$b_2$ Arylen, insbesondere Naphthylen und Phenylen, ggf. substituiert durch ($C_1$-$C_3$)Alkyl, ($C_1$-$C_3$) Alkoxy, insbesondere durch Methyl und in ortho-Position zu der Bindung, die die funktionelle Gruppe trägt, oder Cycloalkylen, insbesondere Cyclohexalkylen sowie
r, s O oder 1, mit der Maßgabe, daß die Summe aus den Werten von r und s mindestens 1 ist,
bedeuten.

4. Silylierungsreagenz nach Anspruch 1, dadurch gekennzeichnet, daß die Gruppe C funktionelle Gruppen umfaßt, die mit aliphatischen und aromatischen Hydroxylgruppen unter Addition reagieren.

5. Silylierungsreagenz nach Anspruch 1 und 4, dadurch gekennzeichnet, daß es als funktionelle Gruppe C Thiol-, Hydroxyl-, Amino-, Epoxy-, gebunden über Alkylen, Aziridino-, Carboxyl- und deren Derivate sowie insbesondere Isocyanat, Carbodiimid und Lactone enthält.

6. Silylierungsreagenz nach Anspruch 1 oder 2, da durch gekennzeichnet, daß die Silanylgruppen nach der allgemeinen Formel II als Rest R ($C_1$-$C_3$)Alkyl, insbesondere Methyl, enthalten.

7. Silylierungsreagenz nach einem oder mehreren der Ansprüche 1 bis 3, dadurch gekennzeichnet, daß die Silanylgruppen nach der allgemeinen Formel II zwei oder vier Siliciumatome enthalten.

8. Silylierungsreagenz nach einem oder mehreren der Ansprüche 1 bis 7, dadurch gekennzeichnet, daß sie gegenüber Strahlung einer Wellenlänge von größer als 300 nm beständig sind.

FIG. 1

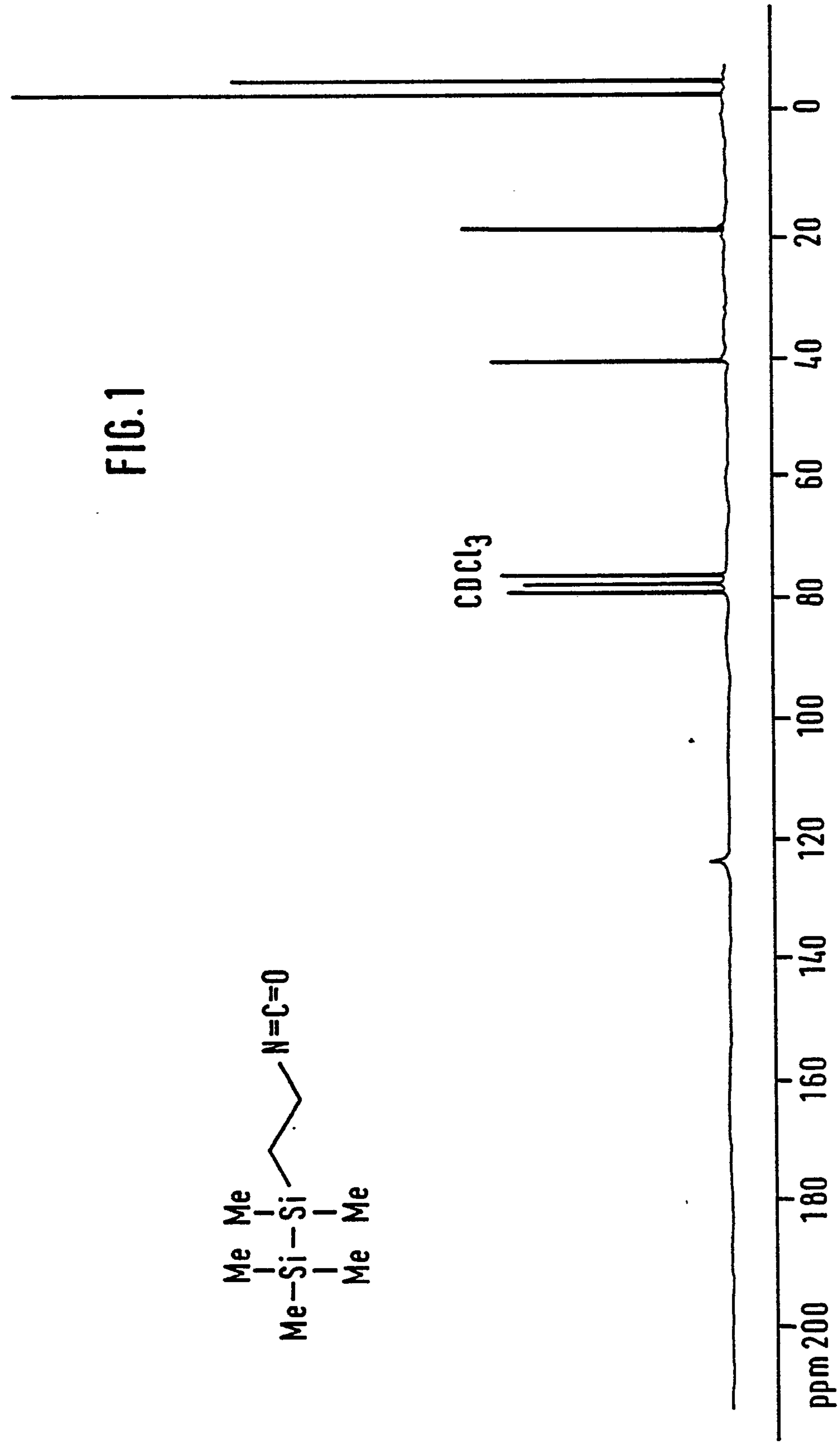


HOECHST AKTIENGESELLSCHAFT
88/K 022

FIG. 2

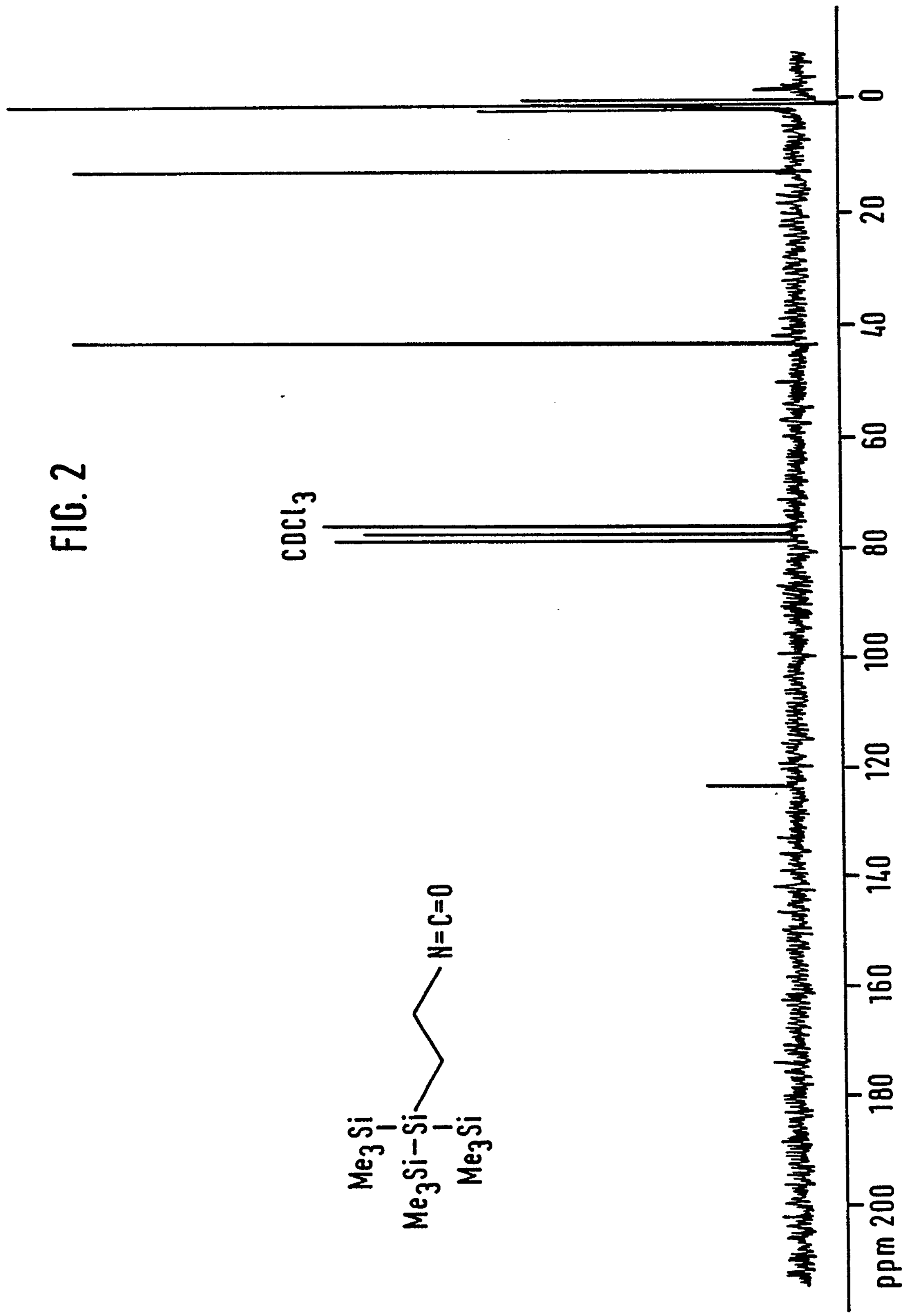


HOECHST AKTIENGESELLSCHAFT
88/K 022